# EUROPEAN PATENT APPLICATION

(11) **EP 1 450 396 A1**
(43) Date of publication of application: **25.08.2004**
(21) Application number: 02803927.9
(22) Date of filing: 25.11.2002
(51) Int. Cl.: H01L 21/304

(54) **PRODUCTION METHOD FOR SILICON WAFER AND SILICON WAFER AND SOI WAFER**

(30) Priority: 28.11.2001 JP 2001362417
(71) Applicant: Shin-Etsu Handotai Co., Ltd, Tokyo 100-0005 (JP)
(72) Inventor: IIZUKA, Naoto, Shin-Etsu Handotai Co.Ltd., Nishishirakawa-gun, Fukushima 961-8061 (JP); NIHONMATSU, Takashi, Nagano Denshi Co., Ltd., Kosyoku-shi, Nagano 387-8555 (JP); YOSHIDA, Masahiko, Nagano Denshi Co., Ltd., Kosyoku-shi, Nagano 387-8555 (JP); MIYAZAKI, Seiichi, Nagano Denshi Co., Ltd., Kosyoku-shi, Nagano 387-8555 (JP)
(74) Representative: Cooper, John
(86) International application number: PCT/JP2002/012276
(87) International publication number: WO 2003/046968

(57) **Abstract**

The present invention relates to a method for producing a silicon wafer, wherein the method comprises at least a lapping process by use of loose abrasive grains and an etching process by use of an alkaline etching solution, lapping is performed in the lapping process by use of abrasive grains having a maximum grain diameter of 21 µm or less and an average grain diameter of 8.5 µm or less serving as the loose abrasive grains, and after that, etching is performed in the etching process by use of an alkaline solution having a concentration of an alkaline component of 50% by weight or more serving as the alkaline etching solution, and relates to a silicon wafer produced by the production method. Thus, there can be provided a method for producing a silicon wafer which can prevent degradation of surface roughness of the wafer and flatness of the whole wafer, and a silicon wafer produced by the method.

## Description

### Technical field

The present invention relates to a method for producing a silicon wafer, which can prevent particle generation and degradation of flatness in a production process of silicon wafers. In particular, it relates a lapping and etching processes.

### Background Art

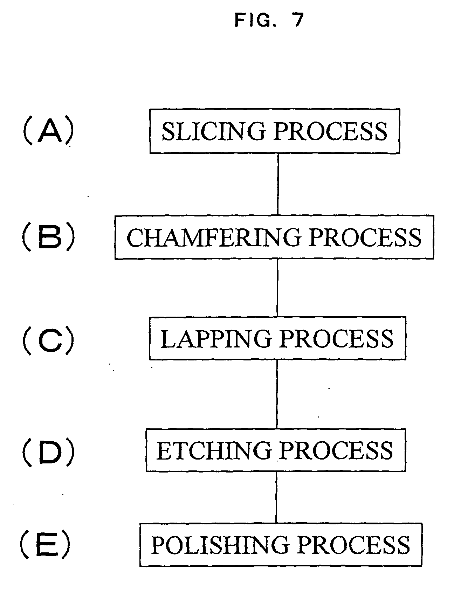

Conventionally, when a silicon wafer used for an integrated circuit such as IC and LSI or a discrete semiconductor element such as a transistor and a diode is produced, the production is performed according to the processes, for example as shown in Fig. 7. First, a silicon ingot grown by the Czochralski method (CZ method), Floating Zone method (FZ method) or the like is sliced into a wafer shape in a slicing process (A) by use of such as an inner diameter slicer or wire saw. Next, in order to prevent such as cracks on a side face of the wafer, a peripheral portion of the wafer is chamfered in a chamfering process (B), and then a surface of the wafer is subjected to lapping by loose abrasive grains in a lapping process (C) to improve flatness. After that, wet etching is performed in an etching process (D) to eliminate mechanical damages generated on the wafer in the above processes. After this etching process, mirror-polishing is performed on one side or both sides of the wafer surface in a polishing process (E), and thereby a mirror-polished silicon wafer is produced.

Generally, as to the abrasive grains used in the lapping process, alumina based fine lapping materials are mainly used. Among them, at present, FO abrasive grains made by FUJIMI INCORPORATED has been used as a lapping material for a semiconductor crystal such as silicon wafers, and they hold usage rate of about 100% in Japan. Particularly, #1000 FO abrasive grain (maximum diameter: 30 µm or less, average grain diameter: 14.0-12.0 µm), #1200 FO abrasive grain (maximum diameter: 25 µm or less, average grain diameter: 10.8-9.2 µm) or the like has been in heavy usage, since the abrasive grains having the above grain size properly match the surface precision of a silicon wafer (see High Precision Processing Technology of Crystal Material for Electronics, pp. 257-261, published by Science Forum Inc., edited by Masahisa MATSUNAGA).

Moreover, in the etching process, the wet etching is performed to eliminate mechanical damages generated in the wafer production process as described above. This wet etching includes acid etching by use of mixed acid consisting of hydrofluoric acid, nitric acid, acetic acid and the like, and alkaline etching by use of an alkali such as sodium hydroxide and potassium hydroxide.

Although, in the above acid etching, an etching rate and the condition of a wafer surface after the etching can be controlled by altering the proportion of the components of the mixed acid, there is a problem that since its etching rate is generally fast, flatness of the wafer improved in the lapping process is degraded.

On the other hand, the above alkaline etching has an advantage that since its etching rate is slow, flatness of the wafer improved in the lapping process can be maintained, and thus the wafer having good flatness can be obtained after the etching. In the recent production of silicon wafers, since very high flatness has been required therein, the alkaline etching has been employed widely.

Conventionally, when alkaline etching is performed, the concentration of an alkaline component in an alkaline etching solution is less than 48-50% by weight in general, and an alkaline solution having the concentration of an alkaline component higher than 50% by weight has not been industrially employed, because there is a problem that crystallization of the alkaline component occurs.

However, such generally employed alkaline etching solutions have the selectivity such that the etching rate on the plane (100) is about 60-100 times different from that on the plane (111). Therefore, because of this selectivity, the alkaline etching has the problem that micro roughness on a wafer surface after etching becomes large.

Namely, if micro roughness on a wafer surface is large (surface roughness is large), it causes the problem of particle generation that, for example, as to convex portions, the convex portions are broken in a device fabrication process, which causes the generation of particles. Moreover, as to concave portions (pits), a stock removal in polishing must be increased, and the increasing of the stock removal causes the problems that the degradation of flatness of wafers and the decrease of production yield in a polishing process are incurred.

In order to solve such problems, there has been suggested an etching method combining alkaline etching with acid etching in which each demerit is solved (Japanese Patent Laid-open (Kokai) No. 11-233485). This etching method can reduce surface roughness of wafers by performing acid etching after alkaline etching, but has problems that performing the acid etching slightly degrades flatness of wafers, and the number of processes is increased. In the other references, there has also been suggested a method by use of a high concentration alkaline solution as disclosed in Japanese Patent Laid-open (Kokai) No. 11-171693 (USP. No. 6099748), but it is difficult to say that the method can solve the above problems sufficiently.

### Disclosure of the Invention

Therefore, the present invention was accomplished in view of the above problems, and its object is to provide a method for producing a silicon wafer which can prevent degradations of surface roughness of the wafer and flatness of the whole wafer, and a silicon wafer with high flatness produced by the method.

In order to achieve the above object, the present invention provides a method for producing a silicon wafer, wherein the method comprises at least a lapping process by use of loose abrasive grains and an etching process by use of an alkaline etching solution, lapping is performed in the lapping process by use of abrasive grains having a maximum grain diameter of 21 µm or less and an average grain diameter of 8.5 µm or less serving as the loose abrasive grains, and after that, etching is performed in the etching process by use of an alkaline solution having a concentration of an alkaline component of 50% by weight or more serving as the alkaline etching solution.

As described above, when a silicon wafer is subjected to the lapping process, the lapping is performed by use of abrasive grains having a maximum grain diameter of 21 µm or less and an average grain diameter of 8.5 µm or less serving as the loose abrasive grains, after that, the etching is performed in the etching process by use of an alkaline solution having a concentration of an alkaline component of 50% by weight or more serving as the alkaline etching solution, and thereby the surface roughness of the silicon wafer after the etching process can be reduced drastically and a silicon wafer with good flatness can be made. Moreover, according to this, since a stock removal in a subsequent polishing process can be reduced, the degradation of flatness of the wafer can be prevented, and the reduction of polishing time, the reduction of the amount of a polishing pad and polishing agent to be used or the like are expected, and therefore it also leads to the improvement of the productivity and the reduction of the costs.

In this case, it is preferable that the alkaline component in the alkaline solution is sodium hydroxide.

As described above, since the alkaline component in the alkaline solution is sodium hydroxide, the effect that surface roughness is remarkably reduced can be obtained greatly, and since it is inexpensive, the cost can be reduced.

Moreover, in this case, it is preferable that the etching is performed while controlling a temperature of the alkaline solution within a range of 80°C-300°C.

As described above, since the etching is performed while controlling a temperature of the alkaline solution within the range of 80°C-300°C, the etching can be performed while maintaining the state of the solution having high concentration without generation of crystallization of the alkaline component even when the concentration of the alkaline component is increased. For example, when the concentration of the alkaline component is 80% by weight, the temperature of the alkaline solution is controlled at 200°C, and when the concentration of the alkaline component is 90% by weight, the temperature of the alkaline solution is controlled at a high temperature of 300°C.

In this case, it is preferable that an alumina based fine lapping material is used as the loose abrasive grains, and it is also preferable that the alumina based fine lapping material is an artificial emery lapping material made of a mixture of alumina abrasive grains and zircon abrasive grains.

To give a specific example of a lapping material serving as such loose abrasive grains, the FO abrasive grain made by FUJIMI INCORPORATED is available. As described above, the FO abrasive grain of #1200 or rougher holds usage rate of about 100% in Japan. The lapping is performed by use of the FO abrasive grain of a higher number (abrasive grains of #1500 or finer) than a conventional one, and thereby the generation ratio of damages and scratches can be lowered, and the production can be performed efficiently.

Furthermore, it is preferable that the concentration of the alkaline component in the alkaline solution is 70% by weight or less.

Although a higher concentrated alkaline solution is much more preferable, if the concentration of the alkaline component is 70% by weight or less, the etching can be performed under the condition that the temperature of the solution is about 80-90°C, in which operation is relatively easy. In addition, if the concentration variation is controlled by a hydrometer, the concentration of the alkaline solution is stabilized, and the etching can be performed without generation of precipitation of the alkaline component in an etching bath.

And, according to the present invention, by the above production method, a silicon wafer of which surface roughness is drastically lowered and which has good flatness can be provided.

Further, according to the present invention, there can be provided a silicon wafer, wherein both sides of the wafer are etched surfaces, and in a peripheral portion of the wafer except a region within 1 mm from a peripheral end of the wafer on the etched surfaces, an absolute value of a minimum value (sag) of a thickness difference of a shape in the peripheral portion of the wafer against a reference surface obtained from a thickness displacement of the wafer surface in a central region of the wafer is 0.2 µm or less.

As described above, since the silicon wafer of the present invention has an absolute value of the sag of 0.2 µm or less in the peripheral portion of the wafer except a region within 1 mm from a peripheral end of the wafer on the etched surfaces, the silicon wafer has a flat surface up to a peripheral portion of the wafer, and therefore the silicon wafer having a large available region for fabrication of devices can be made.

Furthermore, in the peripheral portion of the wafer except a region within 1 mm from a peripheral end of the wafer on the etched surfaces, an absolute value of a maximum value (rise) of a shape in the thickness difference of a peripheral portion of the wafer against the reference surface can be 0.2 µm or less.

Since the silicon wafer of the present invention can have not only the absolute value of the sag of 0.2 µm or less but also the absolute value of the rise of 0.2 µm or less in the peripheral portion of the wafer except a region within 1 mm from a peripheral end of the wafer on the etched surfaces, the silicon wafer having a further flat surface up to the peripheral portion of the wafer can be made.

In this case, it can become a silicon wafer, wherein a plane orientation of the silicon wafer is (100) and the etched surfaces of the silicon wafer have etch pits forming square-shaped openings with four sides along a crystal orientation <110>, and moreover, a silicon wafer wherein an average size of the etch pits is 6 µm or less.

As described above, the etched surfaces of the silicon wafer of the present invention have etch pits forming approximately square-shaped openings, and the size of the etch pits can be reduced at 7 µm or less, or even 6 µm or less on average, which was not obtained by conventional etching, and therefore, flatness of the etched surfaces can be further improved. And, for example, such an etched surface having a small size of etch pits is used as a surface for chucking in the case that dry etching or the like is performed, and thus chucking failure can be reduced drastically. Moreover, since such etch pits of small size can be eliminated easily by subjecting the etched surface to mirror-polishing, a high quality silicon wafer can be made, and a stock removal in polishing can be reduced, and thus the productivity can be improved. In addition, there may be the case that the etched surface is, for example, polished with slight stock removal of 0.5 µm or less to be used. In the present invention, such a case is also included as the etched surface according to the present invention as far as the etch pits remain thereon. Further, as to the plain orientation (100) according to the present invention, not only the wafer of which plain orientation is exactly (100) but also the wafer of which plain orientation is inclined up to about 4° from (100) are included. Even if the wafer has a slight inclination or, so-called, off-angle for the plane orientation (100) as described above, flatness of the etched surface can be further improved as in the above, and therefore, effects such as the reduction. of chucking failure and the improvement of its productivity can be realized.

On the other hand, the above silicon wafer can become a silicon wafer, wherein a conductivity type is p-type, a resistivity is 0.01 Ω • cm or less, a plane orientation is (100), and the etched surfaces of the silicon wafer have etch pits forming square-shaped openings with four sides along a crystal orientation <110>, and moreover, a silicon wafer wherein an average size of the etch pits is 7 µm or less.

Generally, in the case that a silicon wafer has a low resistivity, in particular, a silicon wafer is p-type and has a resistivity of 0.01 Ω • cm or less, it is difficult to reduce sizes of etch pits because of the decrease of its etching rate. However, according to the present invention, even if a silicon wafer is p-type and has a low resistivity of 0.01 Ω • cm or less, the average size of etch pits in the silicon wafer can be reduced to 8 µm or less, or further 7 µm or less. Therefore, since the silicon wafer exceeds in flatness of the etched surface as described above, chucking failure in dry etching can be reduced drastically, and further, by polishing the etched surface, a high quality silicon wafer can be obtained with high productivity. Additionally, in the case that the silicon wafer having such a low resistivity is subjected to epitaxial growth, it can be made into an epitaxial wafer having gettering ability, and therefore, the wafer can be effectively used as a high quality substrate for epitaxy.

Further, on the aforementioned etched surfaces in a central region of the wafer, an average value of a variation (waviness) of a thickness displacement on the wafer surface can be 0.04 µm or less.

As described above, since the silicon wafer of the present invention can have average value of the waviness of 0.04 µm or less, it becomes an extremely flat silicon wafer.

Furthermore, according to the present invention, there can be provided a silicon wafer, wherein at least one side of the etched surfaces of the above silicon wafer of the present invention is mirror-polished.

As described above, if the silicon wafer is obtained by mirror-polishing the silicon wafer of the present invention having etch pits of small size and a flat etched surface up to a peripheral portion of the wafer, it can be a mirror-polished silicon wafer which exceeds in flatness and surface roughness, and which has a nanotopography of an extremely high level.

In this case, the silicon wafer can be made into a silicon wafer, wherein in a peripheral portion of the wafer except a region within 1 mm from a peripheral end of the wafer on the mirror-polished surface of the silicon wafer, an absolute value of a minimum value (sag) of a thickness difference of a shape in the peripheral portion of the wafer against a reference surface obtained from a thickness displacement of the wafer surface in a central region of the wafer is 0.5 µm or less.

As described above, since the silicon wafer of the present invention is a wafer wherein in a peripheral portion of the wafer except a region within 1 mm from a peripheral end of the wafer on the mirror-polished surface, an absolute value of a sag is 0.5 µm or less, it becomes a high quality mirror-polished silicon wafer of which surface is very flat up to a peripheral portion of the wafer.

Furthermore, in this case, the silicon wafer can be made into a silicon wafer, wherein in a peripheral portion of the wafer except a region within 1 mm from a peripheral end of the wafer on the mirror-polished surface, an absolute value of a maximum value (rise) of a thickness difference of a shape in the peripheral portion of the wafer against a reference surface obtained from a thickness displacement of the wafer surface in a central region of the wafer is 0.07 µm or less.

As described above, since the silicon wafer of the present invention is a wafer wherein in a peripheral portion of the wafer except a region within 1 mm from a peripheral end of the wafer on the mirror-polished surface, an absolute value of a rise is 0.07 µm or less as well as an absolute value of a sag is 0.5 µm or less, it becomes a mirror-polished silicon wafer having further high flatness up to a peripheral portion of the wafer.

Further, according to the present invention, there can be provided an SOI wafer having a structure such that an insulator film and an SOI layer are laminated in order on the mirror-polished surface of the above mirror-polished silicon wafer.

For example, if an SOI wafer is produced according to a bonding method by use of the mirror-polished silicon wafer of the present invention, a width of an unbonded portion where a peripheral portion of the wafer is not bonded when the wafers are bonded each other can be extremely reduced, and therefore it becomes an SOI wafer having an SOI layer up to a region near a peripheral end of the wafer. On the other hand, if an SOI wafer is produced according to a SIMOX method by use of the silicon wafer of the present invention, the wafer can have a flat surface up to its peripheral portion, and therefore it becomes an SOI wafer having a large available region for fabrication of devices up to a region near a peripheral end of the wafer.

Also, according to the present invention, there is provided a silicon wafer, wherein the silicon wafer has an etched surface on at least one main surface side, an plain orientation of the silicon wafer is (100), the etched surface has etch pits forming square-shaped openings with four sides along a crystal orientation <110>, and an average size of the etch pits is 6 µm or less.

As described above, in the silicon wafer of the present invention, an average size of the etch pits forming square-shaped openings on the etched surface can be 6 µm or less, which is very small and can not be obtained conventionally. And, if such an etched surface having etch pits of small size is used as a surface for chucking in the case that a dry etching or the like is performed, chucking failure can be extremely reduced. Moreover, since etch pits of small size can be easily eliminated by polishing the etched surface, a high quality silicon wafer which exceeds in a nanotopography can be made, and since a stock removal in polishing can be reduced, its productivity can be improved.

Further, the present invention also provides a silicon wafer, wherein the silicon wafer has an etched surface on at least one main surface side, a conductivity type is p-type, a resistivity is 0.01 Ω • cm or less, a plane orientation of the silicon wafer is (100), the etched surface has etch pits forming square-shaped openings with four sides along a crystal orientation <110>, and an average size of the etch pits is 7 µm or less.

As described above, in the case of a p-type silicon wafer having a low resistivity of 0.01 Ω • cm or less, it is generally difficult to reduce the etch pit size. But, in the present invention, even if the silicon wafer has such a low resistivity, the average size of the etch pits in the silicon wafer can be extremely reduced to 7 µm or less. Such an etch pit size of 7 µm or less has not been obtained from a conventional low resistivity wafer. Therefore, as described above, since the wafer exceeds in flatness of the etched surface, chucking failure in dry etching can be extremely reduced. Further, by polishing this etched surface, the silicon wafer becomes a high quality silicon wafer which exceeds in nanotopography. Furthermore, since such a low resistivity silicon wafer can be made into an epitaxial wafer having gettering ability by performing epitaxial growth, the wafer can be effectively used as a high quality substrate for epitaxy.

In this case, on the etched surface in a central region of the wafer, an average value of a variation (waviness) of a thickness displacement on the wafer surface can be 0.04 µm or less.

As described above, in the silicon wafer of the present invention, since an average value of a waviness is 0.04 µm or less, it becomes an extremely flat silicon wafer.

In this case, a main surface which is the opposite side of the etched surface can be a mirror-polished surface, and moreover on the mirror-polished surface of the silicon wafer, a structure such that an insulator film and an SOI layer are laminated in order can be formed.

As described above, if a main surface which is the opposed side of the etched surface of the silicon wafer is a mirror-polished surface, the structure such that an insulator film and an SOI layer are laminated in order can be easily formed on the mirror-polished surface of the wafer by a boding method, SIMOX method or the like to make an SOI wafer. And, since such an SOI wafer has etch pits of very small size on the etched surface as described above, it becomes a very high quality SOI wafer such that a chucking failure can be extremely reduced in the case that the etched surface is used as a surface for chucking.

As described above, according to the present invention, there can be provided a method for producing a silicon wafer wherein the method comprises a lapping process by use of loose abrasive grains and an etching process by use of an etching solution, abrasive grains having a maximum gain diameter of 21 µm or less and an average grain diameter of 8.5 µm or less is used as the loose abrasive grains, and an alkaline solution having a concentration of an alkaline component of 50% by weight or more is used as the etching solution. Thereby, for example, a silicon wafer of which surface roughness is greatly reduced and of which flatness is good can be produced. Moreover, since it is possible to reduce a polishing time in a subsequent polishing process and to reduce consumed quantities of a polishing pad and a polishing agent, the improvement of productivity and the reduction of costs can be achieved. Also, the silicon wafer and SOI wafer of the present invention can be made into high quality wafers having a large available region for fabrication of devices up to a region near a peripheral end of the wafer.

### Brief Explanation of the Drawings

Fig. 1 is a flowchart showing the production method of the silicon wafer of the present invention.
Figs. 2 are observation views showing pits on surfaces of silicon wafers after etching observed with a microscope.
Fig. 3 is a bird's-eye view of a silicon wafer produced by the production method of the silicon wafer of the present invention.
Fig. 4 is a bird's-eye view of a silicon wafer produced by the production method of the silicon wafer in which etching process is conducted by an etching method combining alkaline etching and acid etching.
Fig. 5 is a schematic explanatory view showing one example of a lapping apparatus used in a lapping process.
Fig. 6 is a schematic explanatory view showing one example of a polishing apparatus used in a polishing process.
Fig. 7 is a flowchart showing a conventional method for producing a silicon wafer.
Fig. 8 is a sectional schematic view showing schematically a shape of a silicon wafer.
Fig. 9 is a graph explaining the relation between the thickness displacement of the silicon wafer and the rise, sag, and waviness of the wafer.
Fig. 10 is a graph showing the measurement results of the rise, sag, and waviness of the silicon wafers according to Example 4 and Comparative examples 7 and 8.
Fig. 11 a graph showing the measurement results of sizes of etch pits of the silicon wafers according to Examples 5-13 and Comparative examples 9 and 10.
Fig. 12 is a graph showing the results of nanotopographies in the silicon wafers of Example 6 and Comparative example 9 measured in WINDOW SIZE of the region of 0.5 mm × 0.5 mm.
Fig. 13 is a graph showing the results of nanotopography in the silicon wafers of Example 6 and Comparative example 9 measured in WINDOW SIZE of the region of 10 mm ×10 mm.
Fig. 14 is a graph showing the measurement results of sizes of sags in the silicon wafers according to Example 14 and Comparative example 11.
Fig. 15 is a graph showing the measurement results of sizes of rises in the silicon wafers according to Example 14 and Comparative example 11.
Fig. 16 is a flowchart of producing an SOI wafer by an ion implantation delamination method.
Fig. 17 is a graph showing the measurement results of widths of unbonded regions in the SOI wafers according to Example 15 and Comparative example 12.
Fig. 18 is an explanatory view for explaining a measurement method of a waviness of the wafer.

### Best Mode for Carrying out the Invention

Hereafter, embodiments of the present invention will be explained in detail. However, the present invention is not limited thereto.

The inventors of the present invention found that an alkaline solution having a concentration of an alkaline component of 50% by weight or more was prepared, alkaline etching was performed by use of this solution as an etching solution of a silicon wafer, and thereby surface roughness of the silicon wafer was improved, and further found that lapping was performed in a previous process of alkaline etching by use of loose abrasive grains having a maximum grain diameter of 21 µm or less and an average grain diameter of 8.5 µm or less, and thereby the effect of preventing degradations of surface roughness and flatness were attained remarkably, and they came to accomplish the present invention.

Namely, in a method for producing a silicon wafer comprising at least a lapping process by use of loose abrasive grains and an etching process by use of an alkaline etching solution, lapping is performed in the lapping process by use of abrasive grains having a maximum grain diameter of 21 µm or less and an average grain diameter of 8.5 µm or less as the loose abrasive grains, and after that, etching is performed in the etching process by use of an alkaline solution having a concentration of an alkaline component of 50% by weight or more as the alkaline etching solution, and thereby, a silicon wafer of which surface roughness is drastically reduced and of which flatness is good can be obtained.

As described above, by using the loose abrasive grains which are finer (higher number) than conventional ones in the lapping process, mechanical damages can be reduced and generation of deep pits can be prevented in particular.

And if this lapped wafer having few mechanical damages is subjected to etching by use of an alkaline etching solution of which concentration of an alkaline component is made high, surface roughness of the silicon wafer is considerably reduced. In the case that etching is performed by use of an etching solution in which a concentration of an alkaline component is 50% by weight or more, its etching rate is rapidly decreased, and thereby the influence on selectivity of the alkali etching is lowered. Thereby, a uniform etching can be realized, surface roughness can be improved, and sizes and depths of pits can be reduced. According to the present invention, in the lapping process performed prior to the etching process, the process is performed by use of loose abrasive grains having a maximum grain diameter of 21 µm or less and an average grain diameter of 8.5 µm or less, and thereby a uniform etching can be performed, surface roughness can be improved, and the problem of a particle generation and degradation of flatness are remarkably improved.

Moreover, as described above, if the surface roughness of the wafer after the etching process is small, a stock removal in the polishing process can be reduced. Thereby, a silicon wafer having higher flatness can be produced, and its productivity can be improved.

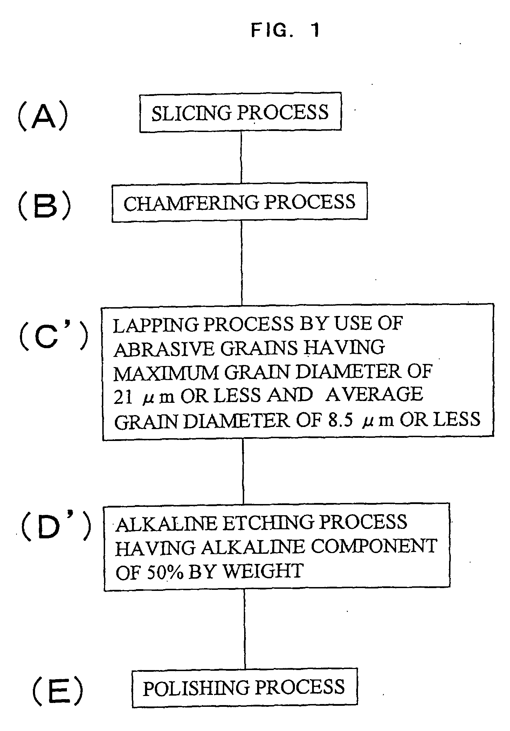

Hereafter, the production method of silicon wafer according to the present invention will be explained in detail with reference to Fig. 1.

First, as in a conventional production method of a silicon wafer, a silicon ingot grown by a method such as the CZ method or FZ method is sliced in a slicing process (A) by use of an inner diameter slicer, wire saw or the like, and a peripheral portion of the wafer is chamfered in a chamfering process (B). After that, in the method for producing a silicon wafer of the present invention, lapping is performed in a lapping process (C') by use of loose abrasive grains having a maximum grain diameter of 21 µm or less and an average grain diameter of 8.5 µm or less, and then, etching is performed in an etching process (D') by use of an alkaline solution in which an alkaline component is contained at a high concentration of 50% by weight or more serving as an alkaline etching solution. After this etching process (D'), a polishing process (E) is performed in which one side or both sides of the wafer surface is generally subjected to mirror-polishing.

Namely, in the method for producing a silicon wafer of the present invention, the lapping process (C') and etching process (D') are improved in particular, and the other processes before and after the above processes are the same as the conventional processes in principle.

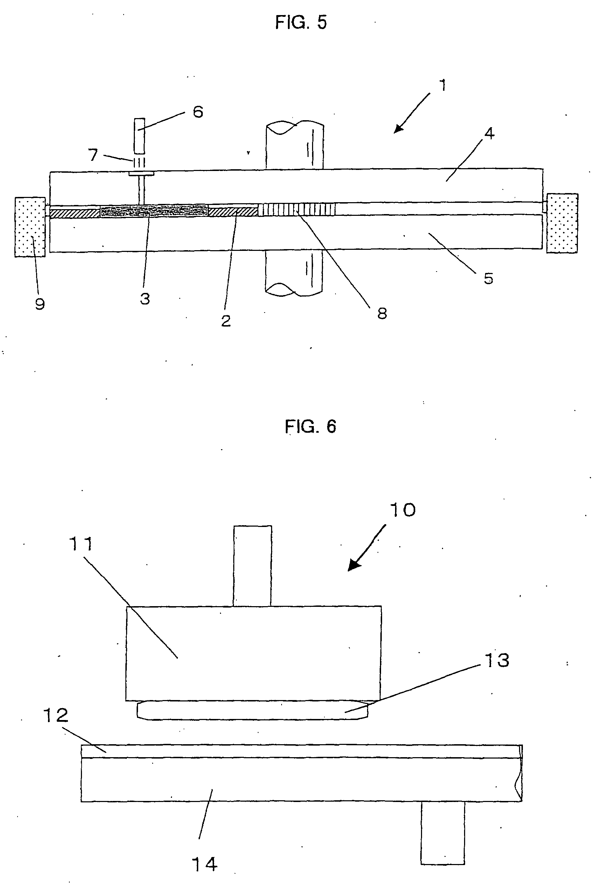

At this point, the specific lapping method performed in the lapping process (C') of the present invention will be explained. Although one example of a lapping apparatus is shown in Fig. 5, the present invention is not limited thereto, and those possible to perform lapping by use of loose abrasive grains having the predetermined grain size are sufficient.

First, a carrier 2 is engaged with a sun gear 8 and an internal gear 9 in a lapping apparatus 1, and a wafer 3 is set in a holder of the carrier 2. After that, both sides of the wafer 3 are held so as to put the wafer 3 between an upper turn table 4 and a lower turn table 5, and then, the carrier 2 performs Sun-and-planet motion by the sun gear 8 and the internal gear 9 while supplying loose abrasive grains 3 from a nozzle 6, and simultaneously the upper turn table 4 and the lower turn table 5 are rotated in relative directions each other, and thereby both sides of the wafer 2 can be subjected to a lapping process simultaneously.

In this case, abrasive grains having a maximum grain diameter of 21 µm or less and an average grain diameter of 8.5 µm or less are used as loose abrasive grains supplied from the nozzle 6. As described above, by use of the abrasive grains having a maximum grain diameter of 21 µm or less and an average grain diameter of 8.5 µm or less as loose abrasive grains in the lapping, mechanical damages can be reduced, surface roughness after the etching can be lowered, and generation of deep pits can be prevented particularly.

Further, in this case, it is preferable that an alumina based fine lapping material is used as loose abrasive grains, and further, it is preferable that the alumina based fine lapping material is an artificial emery lapping material made of a mixture of alumina abrasive grains and zircon abrasive grains. As described above, by using the alumina based fine lapping material, in particular, the artificial emery lapping material made of a mixture of brown alumina abrasive grains and zircon abrasive grains as loose abrasive grains, generation of damages and scratches on the wafer surface caused in the lapping can be reduced.

At present in Japan, as the above artificial emery lapping material, #1200 FO abrasive grain or #1000 FO abrasive grain, which is rougher than #1200, (made by FUJIMI INCORPORATED) is commonly used. Therefore, since the loose abrasive grain used in the lapping process of the present invention has a maximum grain diameter of 21 µm or less and an average grain diameter of 8.5 µm or less, when it is represented by grain size standard of the FO abrasive grain, it can be represented as #1500 FO abrasive grain (Maximum grain diameter: 21 µm, Average grain diameter: 8.5-7.3 µm) or finer FO abrasive grain than #1500, (for example, #2000 FO abrasive grain (Maximum grain diameter: 17 µm, Average grain diameter: 6.8-5.8 µm), #4000 FO abrasive grain (Maximum grain diameter: 11 µm, Average grain diameter: 3.4-2.6 µm) or the like), and it is preferable that lapping is performed by use of FO abrasive grains as the above.

However, the loose abrasive grain used in the method for producing a silicon wafer of the present invention is not limited to the above FO abrasive grains, and based on the grain size standards defined by Japanese Industrial Standards (JIS), for example, alumina based abrasive grains having a grain size of #2500 (Maximum grain diameter: 22 µ m, Average grain diameter: 7.1-5.9 µm) or a finer grain size can be used as the loose abrasive grain.

Also, in this case, it is preferable that if the grain size of the loose abrasive grain is much finer, the size and depth of pits existing on the wafer surface after etching can be further reduced. However, on the contrary, the grain size of the abrasive grains is too fine, lapping can not be performed sufficiently, and its processing takes a long time. Therefore, in consideration of lapping ability or the like, it is preferable that the abrasive grain rougher than about #4000 FO abrasive grain represented in the grain size standards of FO abrasive grain or about #6000 abrasive grain represented in Japanese Industrial Standards is used.

By such a method, both sides of a silicon wafer are subjected to lapping of about 20-100 µm in total. If the lapping is performed in such a manner, surface conditions of the wafer is stable, mechanical damages are reduced, and the wafer becomes one which hardly suffers from a selective etching in a subsequent etching process. Therefore, the wafer can have good surface conditions for use in the etching process.

Next, the specific method of an etching process in the case of the method for producing a silicon wafer of the present invention will be explained. In the etching process of the present invention (Fig.1 (D)), as described above, etching is performed by using an alkaline solution in which an alkaline component is high concentration of 50% by weight or more as an alkaline etching solution to immerse the lapped silicon wafer therein.

As described above, the etching is performed by making the concentration of an alkaline component in the alkaline etching solution high, and immersing a silicon wafer therein for a predetermined time and so on, and thereby mechanical damages can be eliminated without degradation of flatness of the silicon wafer, and moreover degradation of its surface roughness can be prevented. This is because if the concentration of an alkaline component in the alkaline etching solution is 50% by weight or more, the etching speed in etching is rapidly decreased, and thereby the influence on the selectivity of the alkali etching can be reduced. Thereby, a uniform etching can be realized, surface roughness of the wafer can be improved, and pit size and the like can be reduced.

However, generally, if an alkaline component in the alkaline solution is over 55.0% by weight, there may be a case that the alkaline component is precipitated in an etching bath. In the present invention, it is important to maintain the state of the solution without precipitation of the alkaline component in the alkaline solution of a high concentration. Therefore, it is preferable that etching is performed while controlling a temperature of the alkaline solution at 80°C or more, in particular, within the range of 80-300°C, and thereby, the etching can be performed without precipitation of the alkaline component in the alkaline solution while maintaining the state of the solution of high concentration. In this case, if the concentration of the alkaline solution is much higher, its temperature must be higher. However, in consideration of easiness of use and the like, it is preferable that the temperature of the alkaline solution is 90°C or less.

Also, it is preferable that sizes of pits to be generated are reduced when the concentration of alkaline component in the alkaline solution is much higher, 80% by weight or 90% by weight. However, even if the temperature of the alkaline solution is controlled within the range of 80-300°C, when the concentration of alkaline component in the alkaline solution is too high, problems that the concentration of the alkaline component in the alkaline solution varies widely, the alkaline component is crystallized and the like may occur. Therefore, it is preferable that the concentration of an alkaline component in the alkaline solution is 70% by weight or less, which is easy to control variation of the concentration.

At present, such an alkaline solution having the alkaline component of high concentration described above is not offered commercially. Therefore, after commercial alkaline granules of high purity or an alkaline solution of a low concentration is previously evaporated in an etching bath to concentrate it at a high concentration, it can be used as an alkaline etching solution.

Also, the alkaline component used in the etching solution of the present invention is not limited particularly as long as silicon can be etched. In consideration of etching ability, hydroxides of alkali metal such as sodium hydroxide or potassium hydroxide is preferable and, in particular, sodium hydroxide is preferable. Further, in the present invention, each of these alkaline components can be used alone, or a plurality of these alkaline components can be used as a mixture. For example, it is possible to mix sodium hydroxide and potassium hydroxide or to use sodium hydroxide alone.

And, the elimination thickness (etching removal) of the silicon wafer etching-eliminated by the etching method of the present invention can be set at a minimum thickness possible to eliminate mechanical damages suffered in the processes before the lapping process, and it is not limited in particular. However, in consideration of variation of penetration depth of mechanical damages necessary to be eliminated, the elimination thickness falls within the range of 15-40 µm in total of both sides of the silicon wafer.

This elimination thickness of the silicon wafer is controlled mainly by adjusting a time of immersing a silicon wafer in an etching solution. Also, on the contrary, the immersing time of a silicon wafer is set depending on the relation between the above described etching removal and the concentration of the etching solution, and thus it is preferable that the immersing time is set so that the etching removal falls within the range of 15-40 µm. Usually, it is about 5-60 minutes.

In addition, when the silicon wafer is immersed in the etching solution, a conventional method such as vibrating a wafer or applying ultrasonic wave to the etching solution can be performed optionally in combination with the method of the present invention so that the etching is performed uniformly.

By the method for producing a silicon wafer of the present invention as described above, there can be provided a silicon wafer of which surface roughness is remarkably reduced and of which flatness is good.

Hereinafter, the silicon wafer of the present invention will be described in detail with reference to drawings.

The silicon wafer of the present invention has etched surfaces on both sides, and it is characterized in that, in a peripheral portion of the wafer except a region within 1 mm from a peripheral end of the wafer on the etched surfaces, an absolute value of a sag is 0.2 µm or less, and moreover, an absolute value of a rise is also 0.2 µm or less.

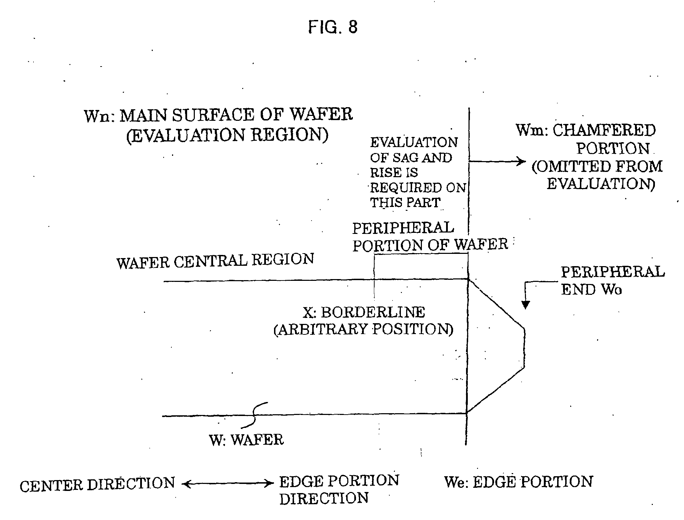

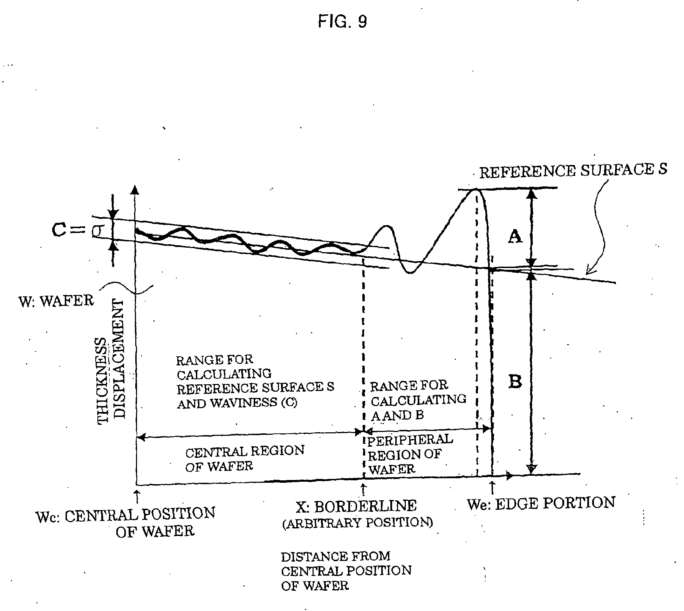

At this point, a rise, sag, and waviness of a silicon wafer will be explained with reference to drawings. A sectional schematic view of a shape of a silicon wafer W is shown in Fig. 8, and a graph which represents schematically thickness displacement on one main surface (wafer surface) of the silicon wafer W is shown in Fig. 9.

As shown in Fig. 8, generally, a chamfered portion Wm is generally formed by the above described chamfering process near a peripheral end Wo of the wafer W to prevent cracks of the wafer or the like. Usually, in the case of an evaluation of a shape of a silicon wafer, the evaluation is conducted without respect to this chamfered portion Wm, i.e., this chamfered portion Wm is excluded from a measuring object. In the present invention, the evaluation is conducted under the condition that a region within 1 mm from a peripheral end of the wafer including the chamfered portion is excluded from the measuring object.

In order to measure the rise and the sag of the silicon wafer, first, the thickness of the wafer on the whole wafer surface within a measuring region is measured by use of, for example, a capacitance type flatness measuring apparatus, and the thickness displacement of the wafer surface is calculated therefrom. And among the obtained thickness displacements of the wafer surface, a reference surface of the wafer is calculated from the thickness displacements of the wafer surface in a central region of the wafer. Namely, the reference surface S is made from the thickness displacements within a central region of the wafer, which is a wide region inside of a peripheral portion of the wafer as shown in Fig. 9. In addition, in Fig. 9, a central position of the wafer is expressed by Wc, a wafer edge portion, which is an outermost peripheral portion in a measuring object region, is expressed by We, and a borderline between a central region of the wafer and a peripheral portion of the wafer is expressed by X, and in the present invention, the position of X is defined as the position of 30 mm from a peripheral end Wo of the wafer (see Fig. 8). In addition, the position of the borderline X is generally decided optionally depending on a silicon wafer to be used, and thus the present invention is not limited thereto.

After the reference surface S is made, as shown in Fig. 9, the obtained reference surface S is extrapolated to the peripheral portion of the wafer to find the thickness difference of the shape in the peripheral portion of the wafer compared to the reference surface S. And, a maximum value of the thickness difference of the shape in the peripheral portion of the wafer compared to the reference surface S is defined as a rise (A), and its minimum value is defined as a sag (B). Further, the thickness variation σ in the central region of the wafer is defined as a waviness (C).

As to the silicon wafer of the present invention, as described above, in the peripheral portion of the wafer except the region within 1 mm from the peripheral portion of the wafer, the absolute value of the sag is 0.2 µm or less, and the absolute value of the rise is also 0.2 µm or less. Therefore, the silicon wafer can be made into a high quality silicon wafer of which flatness is highly maintained up to the peripheral portion of the wafer and which has a large available region for fabrication of devices.

Further, according to such a silicon wafer of the present invention, since the average value of the waviness on the etched surfaces shows 0.04 µm or less, it can be a wafer having very high flatness on the central region of the wafer.

Furthermore, when a plane orientation of the silicon wafer is (100), after alkaline etching is performed, etch pits forming square-shaped openings with four sides along a crystal orientation <110> are formed on the etched surfaces. However, according to the silicon wafer of the present invention, the average size of the etch pits becomes small, i.e., 7 µm or less, further, 6 µm or less. Also, there is a case that a silicon wafer is used after subjecting its etched surfaces to polishing slightly. For example, if the stock removal is about 0.5 µm, the size itself of each etch pit is equal or shifted to a lower value compared to each etch pit before polishing, and partially etch pits may be disappeared. On the other hand, in a conventional silicon wafer, in the case that the size of etch pits are reduced by an etching method combining alkaline etching with acid etching, for example, the average value of its size is also about 0.7 µm. Namely, according to the present invention, the sizes of etch pits can be reduced equal level to or further reduced than conventional one. Therefore, the silicon wafer of the present invention has exceptional flatness on the etched surfaces. Accordingly, for example, in the case that an etched surface of a wafer is used as a chucking surface in performing dry etching or the like, there is a problem in conventional techniques that chucking failure is likely to occur in chucking of the wafer because the sizes of conventional etch pits are large. However, if the etched surface of which sizes of etch pits are small as in the present invention is used as a chucking surface, the chucking failure can be reduced drastically.

Further, as aforementioned, if a silicon wafer has a low resistivity, it is generally difficult to make the sizes of etch pits small. However, according to the present invention, even if the silicon wafer is p-type and has a low resistivity of 0.01 Ω • cm or less, the average size of etch pits formed on the etched surfaces can be 8 µ m or less, further, 7 µm or less. Therefore, the above effect of reducing chucking failure can be certainly obtained, and when such a silicon wafer having low resistivity is subjected to epitaxial growth, it can be made into an epitaxial wafer having gettering ability. And therefore, the silicon wafer of the present invention can be used profitably as a high quality substrate for epitaxial growth.

Also, according to the present invention, there can be provided a silicon wafer, wherein both sides of the silicon wafer as described above are etched surfaces, and at least one side of the etched surface is mirror-polished. If the silicon wafer is obtained by mirror-polishing at least one side surface of the silicon wafer of which sizes of etch pits are small and of which both sides are flat etched surfaces up to the peripheral portion of the wafer as described above, it can be made into a mirror-polished silicon wafer having good flatness and surface roughness, and extremely high nanotopography level.

In addition, the term nanotopography (may be called nanotopology) here means unevenness of which wavelength is from about 0.1 mm to 20 mm and of which amplitude is from about several nanometers to 100 nm, and as to its evaluation, vertical intervals of unevenness of only a wafer surface (P-V value; peak to valley) are evaluated in the region of block areas (which is called WINDOW SIZE or the like) of a square having each side of from about 0.1 to 10 mm or a circle having a diameter of from about 0.1 to 10 mm. This P-V value is called a nanotopography height or the like. As to the nanotopography, it is desirable that a maximum value of an unevenness existing within the evaluated wafer surface is small. Usually, a plurality of block areas of squares of 10 mm are measured, and these maximum values of the P-V values are evaluated. When this maximum value is 60 nm or less, it is evaluated as good, and if the value becomes much lower, it is evaluated as a higher quality wafer.

Moreover, according to such a mirror-polished silicon wafer of the present invention, in the peripheral portion of the wafer except a region within 1 mm from a peripheral end of the mirror-polished surface of the wafer, the absolute value of a sag can be 0.5 µm or less and the absolute value of a rise can be also 0.07 µm or less. Therefore, it becomes a mirror-polished silicon wafer having very high flatness up to a region near the peripheral end of the wafer.

And, by use of such a mirror-polished silicon wafer of the present invention, the wafer is processed so as to form an SOI structure such that an insulator film and an SOI layer are laminated in order on the mirror-polished surface side, and thereby the high quality SOI wafer having a large available region for fabrication of devices up to a region near the peripheral end of the wafer can be made.

In this case, a method for forming an SOI structure on the mirror-polished surface side of the silicon wafer is not limited particularly, and an SOI wafer can be manufactured by, for example, a bonding method, SIMOX method or the like, which is conventionally performed. For example, by use of the silicon wafer of the present invention, an SOI wafer can be manufactured by an ion implantation delamination method, which is one of bonding methods, (called smart cut (registered trademark) method; see Japanese Patent No. 3048201), and thereby a width of an unbonded region in the peripheral portion which is unbonded when wafers are bonded each other can extremely reduced, and thus it becomes a high quality SOI wafer having an SOI layer up to a region near a peripheral end of the wafer.

Further, by use of the mirror-polished wafer of the present invention, an SOI wafer can be also manufactured by a SIMOX method. The SIMOX (Separation by implanted oxygen) method is the method such that oxygen ion is implanted from the mirror-polished side of the mirror-polished wafer to form an oxygen ion implanted layer, and the oxygen ion implanted layer is changed into a silicon oxide film (buried oxide film) by high temperature heat treatment. An SOI wafer manufactured by the SIMOX method as described above has the feature that flatness of the mirror-polished surface of the mirror-polished wafer before implanting oxygen ion can be maintained in a surface of the SOI wafer. Therefore, if the SOI wafer is manufactured by use of the mirror-polished wafer of the present invention according to the SIMOX method, the surface of the SOI layer has high flatness in not only a central region but also near peripheral end of the wafer, and thus the SOI wafer can have a large available region for fabrication of devices.

Further, the present invention can provide a silicon wafer, wherein the silicon wafer has an etched surface on at least one main surface side, an plain orientation of the silicon wafer is (100), the etched surface has etch pits forming square-shaped openings with four sides along a crystal orientation <110>, and an average size of the etch pits is 6 µm or less.

Furthermore, the present invention can also provide a silicon wafer, wherein the silicon wafer has an etched surface on at least one main surface side, a conductivity type is p-type, a resistivity is 0.01 Ω • cm or less, a plane orientation of the silicon wafer is (100), the etched surfaces have etch pits forming square-shaped openings with four sides along a crystal orientation <110>, and an average size of the etch pits is 7 µm or less.

As described above, the silicon wafer of the present invention becomes a wafer in which the size of etch pits formed on the etched surface can be extremely reduced, which can not be obtained conventionally. Therefore, if such an etched surface having small etch pits is used as a chucking surface in the case of performing a dry etching or the like, chucking failure, which is conventionally seen as a problem, can be reduced drastically. Further, since etch pits can be easily eliminated by polishing this etched surface, a high quality silicon wafer exceeding in a nanotopography can be obtained, and moreover since a stock removal in polishing can be reduced, its productivity can be improved.

Further, even if the silicon wafer of the present invention has a low resistivity of 0.01 Ω • cm or less, since its average size of etch pits is small as 7 µm or less, the silicon wafer can be effectively used as a high quality substrate for epitaxy.

Also, the average value of the waviness on the etched surface of the silicon wafer of the present invention shows 0.04 µm or less, and therefore, it becomes a wafer having also very high flatness in a central region of the wafer.

And, it is possible to make such a silicon wafer of the present invention into a wafer wherein a main surface which is the opposite side of the etched surface is mirror-polished surface, and by forming an SOI structure such that an insulator film and an SOI layer are laminated in order on a mirror-polished surface side of this silicon wafer according to a method such as a bonding method or SIMOX method, an SOI wafer can be produced easily. Such an SOI wafer has etch pits of very small size on the etched surface as described above, and therefore it becomes a very high quality SOI wafer which can reduce chucking failure drastically.

The present invention will be explained hereafter with reference to the following examples and comparative examples of the present invention. However, the present invention is not limited thereto.

### (Examples 1-3 and Comparative Examples 1-5)

First, a p-type single crystal ingot having a diameter of 200 mm (8 inches) and a resistivity of about 8-10 Ω • cm was manufactured by the Czochralski method. In accordance with the flowchart shown in Fig. 1, the obtained ingot was sliced by a wire saw into wafers, and silicon wafers of which peripheral portions were chamfered were prepared.

Next, in the lapping process, the above prepared silicon wafers were subjected to lapping.

In the lapping, the lapping apparatus shown in Fig. 5 was used. As to loose abrasive grains, two kinds of FO abrasive grains of #1500 FO abrasive grain or #1200 FO abrasive grain which are lapping materials made by FUJIMI INCORPORATED were used, and the lapping was performed while supplying it at 1.5 l/min from a nozzle. A stock removal of the lapping was about 70 µm in total of both sides of the silicon wafer. By subjecting the wafer to such processes, two kinds of lapped wafers were obtained.

Next, by use of granulated powder of sodium hydroxide reagents of Cica's first class made by KANTO KAGAKU, sodium hydroxide solutions of three levels of concentrations of 50.0, 55.0, and 58.6% by weight were prepared respectively as alkaline etching solutions. Each etching bath was filled with each sodium hydroxide aqueous solution having the different concentration, and heated to 80°C. After temperature raising, two kinds of the lapped wafers, which had been subjected to lapping as the above, were immersed into each etching bath of which temperature was maintained at 80°C to perform etching, and six kinds of wafers having different production conditions were manufactured. In this case, each stock removal of etching was 20 µm in total of both sides of the wafers. In addition, for comparison, wafers were manufactured by performing lapping in which #1200 or #1500 FO abrasive grain was used as loose abrasive grains, and then, performing etching in which alkaline solution having alkaline concentration of 48.0% by weight was used.

In regard to each wafer manufactured, surface roughness of the wafer was measured by use of a stylus type surface roughness measuring apparatus, SURFCOM (product name, made by TOKYO SEIMITSU CO., LTD.). Production conditions and results of surface roughness of each wafer were shown in the following Table 1.

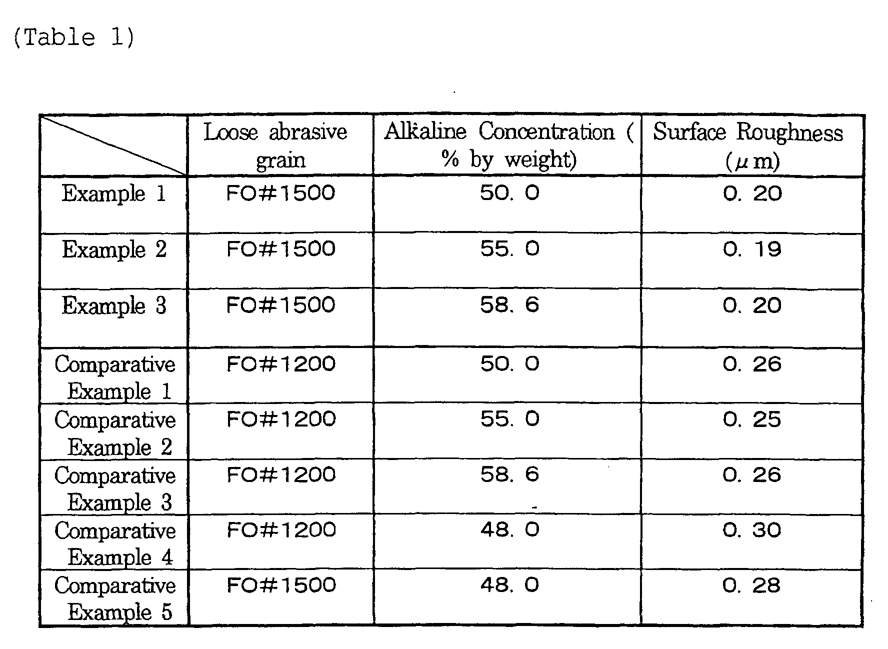

As seen from these results, the etching was performed by use of the alkaline solution having the alkaline concentration of 50% by weight or more, and thereby, the wafers of which surface roughness was 0.26 µm or less were able to be obtained. Further, as compared to the difference of surface roughness depending on the difference of the grain size of the loose abrasive grains, the lapping was performed by use of #1500 FO abrasive grains, and thereby surface roughness after etching was able to be suppressed at 0.20 µm or less. This value is equal or higher level compared to a value of surface roughness obtained in the case that etching is performed by the combination of alkaline etching and acid etching.

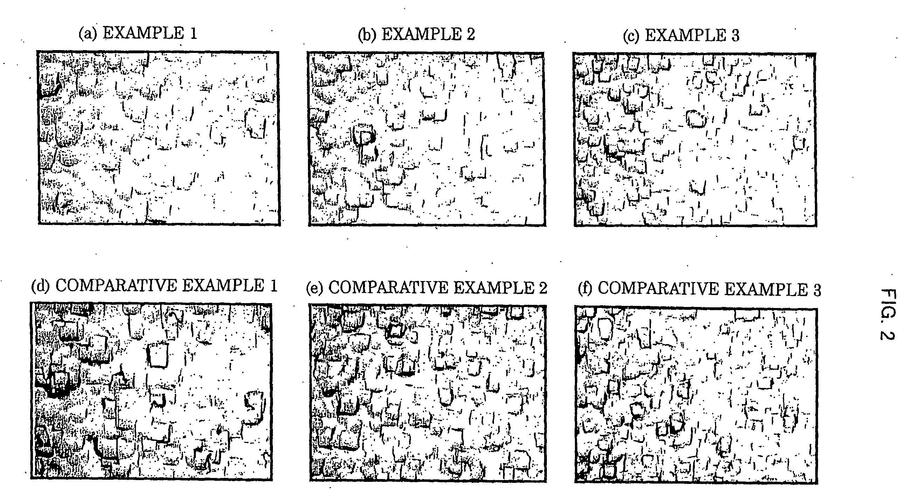

Next, each size of pits generated on the surfaces of each silicon wafer in Examples 1-3 and Comparative Examples 1-3 after the etching was observed. These results were shown in Figs. 2(a)-(f). These are observation views showing conditions of wafer surfaces observed with a light microscope. Square pits forming approximately square-shape openings with four sides along <110> were observed in any wafers. If these pits become shallower and smaller, it is easy to eliminate them in a polishing process, and thus it is preferable. As compared to each wafer in Examples and Comparative Examples, it was found that the wafers in Examples have shallower pits, and when its alkaline concentration is more increased, the pits are more reduced in size.

Next, silicon wafers (Example 2), which has been subjected to lapping by use of #1500 FO abrasive grain and subjected to etching by use of the alkaline solution having the alkaline concentration of 55.0% by weight, were subjected to a polishing process.

The apparatus and polishing conditions used in the polishing process are not limited particularly, and for example, polishing can be performed by the polishing apparatus 10 shown in Fig. 6. First, the wafer 13 was held on a polishing head 11 having a rotating shaft so that a work surface was directed downward, and the wafer was pressed on a turn table 14 (polishing turn table) to which a polishing pad 12 was attached. Next, the wafer 13 and the turn table 14 were rotated to rub the wafer on the turn table while supplying a polishing agent on the polishing pad, and thereby the wafer was polished.

Generally, polishing is performed in a plurality of steps. A stock removal and flatness such as peripheral sags of the wafer were almost determined by an initial polishing (first polishing). Usually, in order to improve very micro unevenness (surface roughness and haze), polishing is repeated while changing hardness of the polishing pad and the polishing agent to be supplied (so-called secondary polishing or finish polishing).

If the surface roughness of a silicon wafer is small after the etching process, a stock removal in a first polishing can be reduced, and thereby sags in a peripheral portion of the wafer can be prevented and the wafer having higher flatness can be produced.

In this polishing process, an alkaline solution (pH is about 10.5) containing colloidal silica serving as abrasive grains used in the first polishing was used as a polishing agent.

The silicon wafers in Example 2 were subjected to the polishing process, and as a result, mirror-polished wafers could be obtained with stock removal of about 10 µm. This value of the stock removal in the polishing is less than the value of the stock removal (about 12 µm) in the polishing process of a conventional production method of a silicon wafer, and it is clear that the present invention can reduce the stock removal in the polishing. Next, GBIR (Global Back Ideal Range) values of a plurality of obtained mirror-polished wafers were measured, and an average value of the GBIR values was calculated to evaluate the flatness of the wafer.

The GBIR is defined generally as a width of maximum and minimum position displacements on the basis of one reference surface which is set within a wafer surface, and its value corresponds to TTV (Total Thickness Variation), which is a conventional specification. In the measurement of the flatness in this time, a capacitance type flatness measuring apparatus, 9900 UltraGage made by ADE Corporation, was used, and the measurement was performed on the condition that the wafer periphery of 2 mm was excluded.

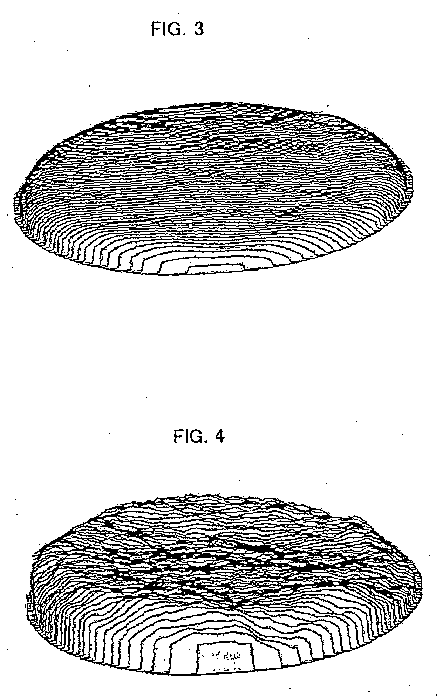

As a result, the average value of GBIR of the obtained mirror-polished wafers was about 0.7 µm, i.e., the wafers had very high flatness. And a bird's-eye view of the silicon wafer obtained by the present invention is shown in Fig. 3.

### (Comparative Example 6)

The silicon wafer which has been subjected to a chamfering process as described above was prepared, the wafer was subjected to lapping by use of #1500 FO abrasive grains, and then subjected to etching by the etching method combining alkaline etching with acid etching, in which surface roughness after etching is very good. After that, the wafer was subjected to the same process as the polishing process performed in the above Example 2, and then the flatness of the obtained wafer was measured. In this case, as to the etching, the alkaline etching of 20 µ m by use of a sodium hydroxide solution having its concentration of 48% by weight, and the acid etching of 10 µm by use of a mixed acid of hydrofluoric acid, nitric acid, and acetic acid were performed. As a result, the flatness of the wafer after polishing was about 1.40 µm on the average of the GBIR value. A bird's-eye view of the obtained silicon wafer is shown in Fig. 4.

As described above, according to the present invention, the lapping is performed by use of abrasive grains of which maximum grain diameter is 21 µm or less and average grain diameter is 8.5 µm or less and the etching is performed by use of the alkaline solution of high concentration of which concentration of the alkaline component is 50% by weight or more, and thereby the silicon wafer could be obtained that has the surface roughness equal or higher level as compared to the conventional etching combining alkaline etching with acid etching which is possible to reduce surface roughness, and that has very high flatness. Namely, according to the present invention, a silicon wafer of which surface roughness is reduced and of which flatness is good can be produced by a simple method without performing a plurality of etching processes.

### (Example 4 and Comparative Examples 7 and 8)

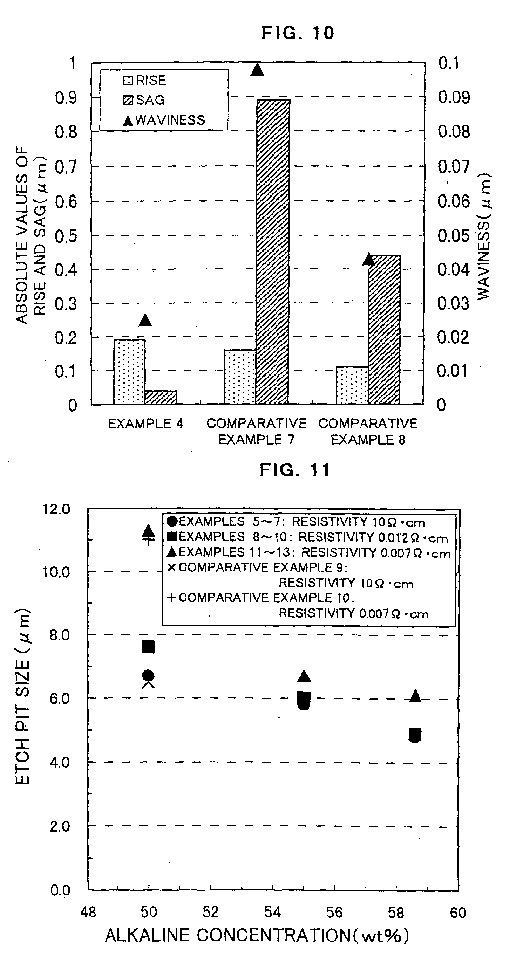

A p-type single crystal ingot having a diameter of 200 mm and a resistivity of about 10 Ω • cm was manufactured by the Czochralski method, and then a silicon wafer (Example 4) was manufactured under the same processing conditions (loose abrasive grain of #1500 FO and NaOH concentration of 55.0% by weight) as in the above Example 2. After that, as to this silicon wafer, three parameters of the rise, the sag, and the waviness of the wafer, which expressed its surface shape characteristics, were measured. The measuring results are shown in Fig. 10. At this point, specific measuring methods of the rise, the sag, and the waviness will be explained.

First, in order to measure the rise and the sag of the silicon wafer having a diameter of 200 mm which was a measuring object, a wafer thickness of the wafer surface to be evaluation regions (except for a region within 1 mm from a peripheral end of the wafer including the chamfered portion) was measured at 0.95 mm intervals by a capacitance type flatness measuring apparatus (9900 UltraGage made by ADE corporation), and each measured wafer thickness was stored sequentially. From these stored wafer thickness, thickness displacement from a wafer central position Wc to a wafer edge position We (a central region of the wafer and a peripheral portion of the wafer) as shown in Fig. 9 were read, and then by use of the thickness displacement from the wafer central position Wc to a borderline X (from the wafer central position to the position of 70 mm in radius) among the read thickness displacement, a reference surface was calculated by a least squares method. Next, in the peripheral portion of the wafer, the difference of the thickness of the shape in the peripheral portion of the wafer against the reference surface (virtual thickness) was analyzed to calculate the absolute values of the maximum and minimum values. And such a calculation of the absolute values of the maximum and minimum values was performed 400 times radially from the center of the wafer, and the measurement was performed so taht an average of the obtained maximum values served as a rise, and the obtained minimum values served as a sag.

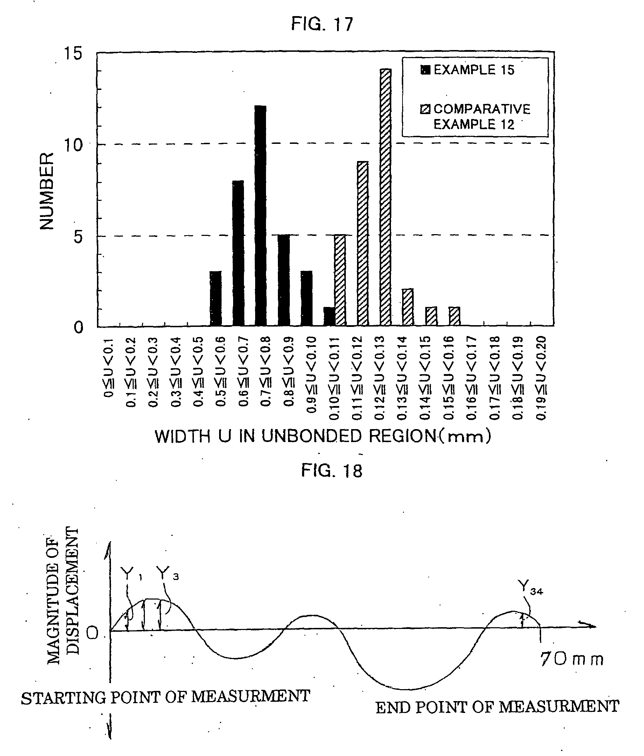

On the other hand, in order to measure a waviness of the wafer, by use of an universal surface shape measuring apparatus (SE-3F type) made by KOSAKA LABORATORY LTD., the central region of the surface of the silicon wafer (from the central position of the wafer to the position of 70 mm in radius) was traced by a stylus to measure only shape components except fine surface roughness components. In this case, as shown in Fig. 18, the thickness displacement in the central position of the wafer to be the starting point of the measurement was matched with the thickness displacement in the end point of the measurement, which was the position of 70 mm in radius from the central position of the wafer so as to have the same height with each other, and the matching point served as an origin. And, absolute values of Y1 to Y34, which were magnitude of thickness displacement from the origin, were measured at 2-mm intervals, and the average value Y thereof was calculated as the average value of the waviness.

As Comparative Example 7, after a silicon single crystal ingot was manufactured under the same condition as in Example 4, lapping was performed by use of loose abrasive grains of #1200 FO, next, etching was performed firstly with stock removal of 4 µm in total of both sides of the wafer by use of a sodium hydroxide aqueous solution having its concentration of 50% by weight, and then secondly with stock removal of 20 µm in total of both sides of the wafer by use of a mixed acid composed of hydrofluoric acid of 50% by weight: nitric acid of 70% by weight: acetic acid of 99% by weight = 1:2:1 (capacity ratio). The silicon wafer was manufactured under the same production conditions as in Example 4 except the above processing conditions. After that, as to this silicon wafer, three parameters of the rise, the sag, and the waviness of the wafer, which expressed its surface shape characteristics, were measured by the above-indicated method. The measuring results are shown in Fig. 10.

As Comparative Example 8, after a silicon single crystal ingot was manufactured under the same condition as in Example 4, lapping was performed by use of loose abrasive grains of #1200 FO, next, etching was performed firstly with stock removal of 20 µm in total of both sides of the wafer by use of a sodium hydroxide aqueous solution having its concentration of 50% by weight, and then secondly with stock removal of 10 µm in total of both sides of the wafer by use of a mixed acid composed of hydrofluoric acid of 50% by weight: nitric acid of 70% by weight: acetic acid of 99% by weight = 1:2:1 (capacity ratio). The silicon wafer was manufactured under the same production conditions as in Example 4 except the above conditions. After that, as to this silicon wafer, three parameters of the rise, the sag, and the waviness of the wafer, which expressed its surface shape characteristics, were measured by the above-indicated method. The measuring results are shown in Fig. 10.

As shown in Fig. 10, as to the silicon wafer of the present invention (Example 4), it was found that both absolute values of the rise and the sag (left vertical axis) were the low value of 0.2 µm or less, in the peripheral portion of the wafer except the region within 1 mm from the peripheral end of the wafer, and thus, the silicon wafer had very flat surface up to a region near the peripheral end of the wafer. It was also confirmed that the average value of the waviness (right vertical axis) was 0.025 µm, and thus, the wafer had good flatness even in the central region of the wafer.

On the contrary, it was found that the absolute values of the sags of the silicon wafers of Comparative Examples 7 and 8 were 0.89 µm and 0.44 µm, respectively, which greatly exceeded 0.2 µm, and thus, flatness in a peripheral portion of each wafer was degraded. Further, it was also found that both average values of the waviness of the wafers of Comparative Examples 7 and 8 exceeded 0.04 µm, and thus, flatness in a central portion of each wafer was degraded as compared to the silicon wafer of the present invention. Furthermore, after three kinds of these wafers were subjected slightly to polishing of which stock removal was 0.5 µm or less on these etched surfaces, the sag, rise, and waviness of each wafer were measured again. The measurement results showed about the same as in Fig. 10.

### (Examples 5-13 and Comparative Examples 9 and 10)

Three p-type silicon single crystal ingots having each diameter of 200 mm, each crystal orientation of <100>, and each resistivity of about 10 Ω • cm, 0.012 Ω • cm, and 0.007 Ω • cm were manufactured by the Czochralski method. Next, from the silicon single crystal ingots having each resistivity, silicon wafers were manufactured under the same processing conditions as in the above Examples 1-3, and nine kinds of silicon wafers were obtained (Examples 5-13).

After that, each size of etch pits forming square-shaped openings with four sides along a crystal orientation <110>, which were formed on the (100) plane serving as etched surfaces of each silicon wafer was measured, and the average value was calculated. In this case, the size of etch pits was measured by holding each silicon wafer so that each notch was located short, and observing a length of a linear direction of etch pits existing on a straight line drawn to <110> direction near the wafer center by use of an optical microscope (with a magnification of 1000). These measured results of size of the etch pits of each silicon wafer are shown in Table 2 as follows and Fig. 11.

Also, as Comparative Example 9, a silicon wafer was manufactured under the same conditions as in the above Comparative Example 8, and the size of etch pits formed on its etched surface was measured by the above measuring method. Further, as Comparative Example 10, a silicon wafer was manufactured under the same conditions as in the above Comparative Example 9 except that its resistivity was about 0.007 Ω • cm, and the size of etch pits formed on its etched surface was measured. These measurement results of Comparative Examples 9 and 10 are also shown in Table 2 and Fig. 11.

**(Table 2)**

| Samples | Resistivity (Ω•cm) | NaOH Concentration (wt%) | Pit Size | | |
|---|---|---|---|---|---|
| | | | Average Value (µm) | Standard Deviation (µm) | Measuring number:n (numbers) |
| Example 5 | 10 | 50 | 6.7 | 1.92 | 20 |
| Example 6 | | 55 | 5.8 | 1.94 | 20 |
| Example 7 | | 58.6 | 4.8 | 1.84 | 20 |
| Examples 8 | 0.012 | 50 | 7.6 | 2.63 | 20 |
| Example 9 | | 55 | 6.0 | 1.83 | 20 |
| Example 10 | | 58.6 | 4.9 | 2.00 | 20 |
| Example 11 | 0.007 | 50 | 11.3 | 5.87 | 13 |
| Example 12 | | 55 | 6.7 | 2.96 | 20 |
| Example 13 | | 58.6 | 6.1 | 2.32 | 20 |
| Comparative Example 9 | 10 | 50 | 6.5 | 2.23 | 15 |
| Comparative Example 10 | 0.007 | 50 | 11 | 5.8 | 13 |

As shown in Fig. 11, the silicon wafers of the present invention can reduce the size of etch pits to the same level or smaller as compared to the wafers having the same resistivity (Comparative Examples 9 and 10), which were subjected to a conventional etching of the combination of alkaline etching and acid etching.

Also, as compared to Examples 5-7 and 8-10 each other, it was confirmed that at the higher alkaline concentration in etching, the size of etch pits becomes smaller, and by making alkaline concentration higher, average size of etch pits was able to be reduced to 7 µm or less, or further, 6 µm or less as indicated in Examples 6, 7, 9, and 10. Such an average size of etch pits of 6 µm or less is very small, which has not been obtained conventionally.

Moreover, there is a tendency that the lower resistivity silicon wafer has, the size of etch pits becomes larger. However, according to the present invention, even in the wafers having low resistivity of 0.01 Ω • cm or less in Examples 11-13, the size of etch pits can be also reduced by making the alkaline concentration higher. For example, as indicated in Examples 12 and 13, according to the present invention, the average size of etch pits can be reduced to 7 µm or less. This average size of the etch pit of 7 µm or less is very small, which has not been obtained by a conventional silicon wafer having a low resistivity of 0.01 Ω • cm or less.

Next, silicon wafers of Example 6 and Comparative Example 9 were evaluated in terms of a nanotopography.

First, one etched surface of each silicon wafer was mirror-polished by use of a polishing apparatus shown in Fig. 6. After that, the mirror-polished surface of each wafer was measured in terms of each nanotopography in two kinds of regions of which WINDOW SIZEs were 0.5 ×0.5 mm and 10 × 10 mm by use of CR-83SQM made by ADE Corporation. In this measurement of the nanotopography, one measurement unit (one pixel) was 0.2 × 0.2 mm. And therefore, in the case that the WINDOW SIZE was 0.5 × 0.5 mm, nine pixels which is three pixels in lengthwise-by-three pixels in crosswise were measured, and the maximum-minimum value (P-V value) in the nine pixels was calculated as a center pixel value. Next, the same calculations were repeated while moving one pixel at a time. And, after the calculations were conducted on the whole wafer surface, each center pixel value was compiled, and then the ratio of areas which is not less than the P-V value of the horizontal axis was plotted to make a graph, and the evaluation of the nanotopography was conducted.

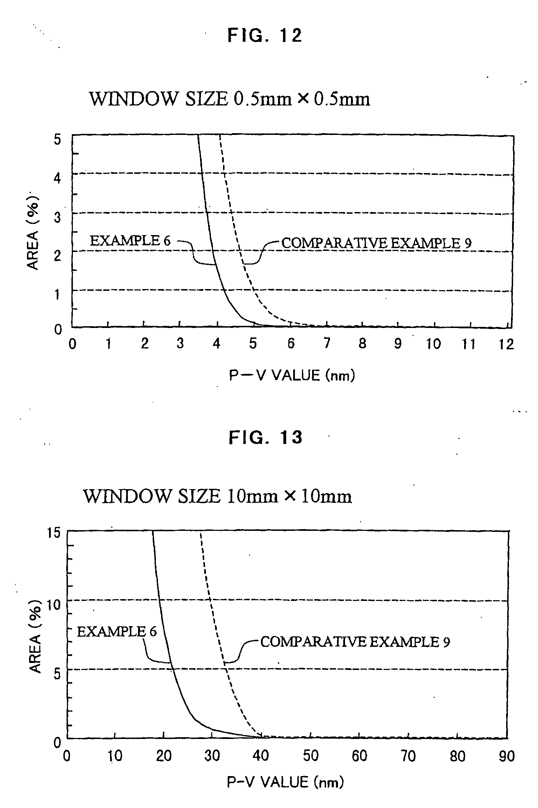

Further, in the case that the WINDOW SIZE was 10 × 10 mm, the measurement was conducted by the same manner as in the case described above that the WINDOW SIZE is 0.5 × 0.5 mm except that the number of pixels was 2500 pixels of 50 by 50 in one WINDOW and the maximum-minimum value (P-V value) in the 2500 pixels was calculated as the center pixel value. The measuring results of the wafers of Example 6 and Comparative Example 9 in terms of the nanotopography are shown in Fig. 12 in the case that the WINDOW SIZE was 0.5 × 0.5 mm, and shown in Fig. 13 in the case of 10 × 10 mm.

As shown in Figs. 12 and 13, it was indicated that in the results of both WINDOW SIZEs, the silicon wafer of Example 6 has smaller P-V values than the silicon wafer of Comparative Example 9, i.e., it was found that the silicon wafer of Example 6 obtains good nanotopography.

### (Example 14 and Comparative Example 11)

As Example 14, a plurality of silicon wafers which were same one as the above Example 6 were prepared. Namely, a p-type silicon single crystal ingot having a diameter of 200 mm, crystal orientation of <100>, and a resistivity of about 10 Ω • cm was firstly manufactured by the Czochralski method, next the obtained silicon single crystal ingot was subjected to slicing and chamfering processes, and then lapping (stock removal of 70 µm) by use of #1500 FO abrasive grains and etching (etching removal of 20 µm) by use of sodium hydroxide having the alkaline concentration of 55.0% by weight were performed in sequence to manufacture silicon wafers.

On the other hand, as Comparative Example 11, a plurality of the silicon wafers which were same one as the above Comparative Example 8 were prepared. Namely, lapping was performed by use of #1200 FO loose abrasive grains, next, etching was performed firstly with stock removal of 20 µm in total of both sides of the wafer by use of a sodium hydroxide aqueous solution having its concentration of 50% by weight, and then secondly with stock removal of 10 µm in total of both sides of the wafer by use of a mixed acid composed of hydrofluoric acid of 50% by weight: nitric acid of 70% by weight: acetic acid of 99% by weight = 1:2:1 (capacity ratio). The silicon wafers were manufactured under the same conditions as in Example 14 except the above processing conditions.

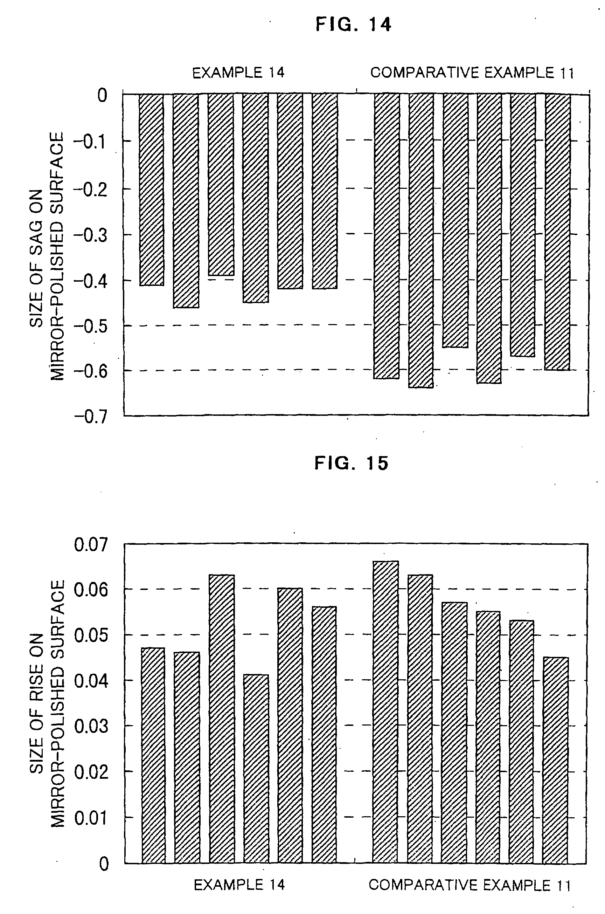

Subsequently, after each of the obtained silicon wafers of Example 14 and Comparative Example 11 was mirror-polished under the same conditions, six wafers were picked up randomly from each of Example 14 and Comparative Example 11, and they were measured in terms of the rise and the sag on mirror-polished surfaces of each wafer. The measurements of the rise and the sag in each wafer were conducted in a peripheral portion of the wafer except a region within 1 mm from a peripheral end of the wafer by the above-indicated measuring method. The measuring results of the size of the sag are shown in Fig. 14, and the measuring results of the size of the rise are shown in Fig. 15.

As clear from Fig. 14, all mirror-polished silicon wafers of the present invention have the absolute value of the sag of 0.5 µm or less, but all wafers of Comparative Example 11 have the absolute value of the sag more than 0.5 µm. Also, as to the rise, all silicon wafers of the present invention have the absolute value of the rise of 0.07 µm or less, which is equal to or smaller than the value of a conventional wafer. Therefore, it was found that the mirror-polished silicon wafer of the present invention is more improved in terms of the flatness in the peripheral portion of the wafer as compared to the conventional wafer.

Further, in this case, as to the silicon wafers of Example 14, the size of the etch pit and the average value of the waviness on etched surfaces which were main surfaces opposite to mirror-polished surfaces were measured. As a result, it was confirmed that the average size of the etch pits in each wafer was about 5.8 µm same as in Example 6, and the average value of the waviness was 0.04 µm or less.

### (Example 15 and Comparative Example 12)

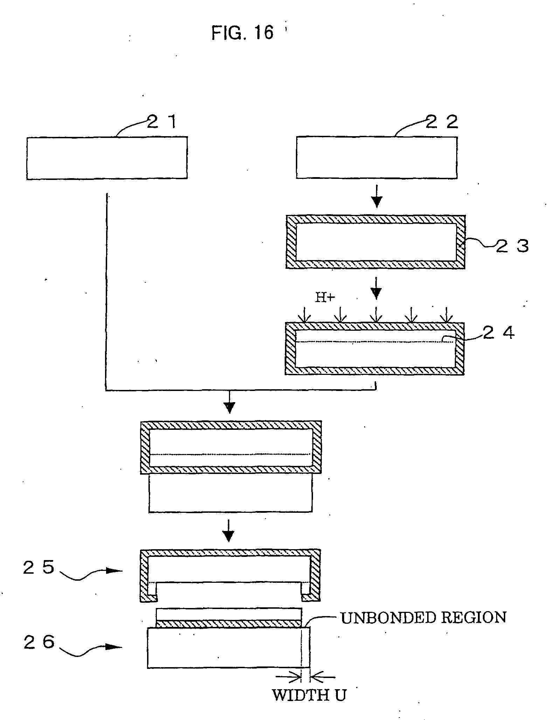

By use of mirror-polished silicon wafers manufactured under the same conditions as Example 14, bonded SOI wafers were manufacture by an ion implantation delamination method (Example 15), and a width U of an unbonded region in the peripheral portion of each of the SOI wafers, was measured. Hereafter, the manufacturing method of an SOI wafer will be explained with reference to Fig. 16.

First, sixty-four mirror-polished silicon wafers of the present invention were prepared, thirty-two wafers out of sixty-four were used as base wafers 21, and the other thirty-two wafers were used as bond wafers 22. At this point, the bond wafers 22 were subjected to heat treatment in an oxidizing atmosphere to form an oxide film 23 of about 150 nm on whole surface of each wafer, and then, hydrogen ions were implanted through the oxide film formed on mirror-polished surface side under the conditions of the accelerating voltage of 56 keV and the doze amount of 5.5 × 10¹⁶/cm², to form a hydrogen high concentration layer (ion implanted layer) 24.

Next, mirror-polished surface of the base wafer 21 was close contact with mirror-polished surface of the bond wafer 22, on which the hydrogen high concentration layer 24 was formed, through the oxide film 23 at room temperature, then, a heat treatment (delamination heat treatment) was performed at 500°C for 30 minutes to delaminate it from the hydrogen high concentration layer, and thus an SOI wafer 26 (Example 15) and a residual wafer 25 were obtained.

As to thirty-two pieces of bonded SOI wafers 26 manufactured as described above, the width U in a radial direction of an unbonded region, which was unbonded in the peripheral portions of each SOI wafer, was measured. The measuring results are shown in Fig. 17 as a histogram plotting the width U of the unbonded region in each sample in abscissa and frequency (the number of samples) in ordinate.

Also, for comparison, by use of mirror-polished silicon wafers manufactured under the same conditions as in Comparative Example 11, bonded SOI wafers were manufactured by an ion implantation delamination method (Comparative Example 12), and each width U of the unbonded region in the peripheral portions of each SOI wafer was measured. The measuring results are also shown in Fig. 17.

As clear from Fig. 17, width U of the unbonded portion of the bonded SOI wafers of Example 15 is more reduced than that of the SOI wafers of Comparative Example 12, and it could become a high quality SOI wafer having an SOI layer up to a region near the peripheral end of the wafer.

The present invention is not limited to the embodiments described above. The above-described embodiments are mere examples, and those having the substantially same structure as that described in the appended claims and providing the similar functions and advantages are included in the scope of the present invention.

For example, in Examples and Comparative Examples as above, when the etching was performed, the temperature of the etching solution was 80°C. However, in consideration of stability of the solution or the like (in order not to generate precipitation of the alkaline component), it is preferable that the temperature is controlled higher than 80°C. For example, the temperature can be controlled at 85°C or 90°C. Further, if the concentration of the etching solution is more increased, the temperature of the solution can be further increased to perform the processing. Even when the temperature is controlled as described above, the wafer having reduced surface roughness and good flatness which are equal to or better than those of the wafers of the above Examples can be easily produced.

Further, in the above Examples, the case that SOI wafers are manufactured by an ion implantation delamination method was explained as examples, but the present invention is not limited thereto. For example, the SOI wafer can be produced by a bonding method such that silicon wafers of the present invention are bonded, and then a thickness of the bonded wafer is reduced by grinding, etching or the like. And moreover it goes without saying that the SOI wafer can be produced by the SIMOX method.

## Claims

1. A method for producing a silicon wafer, wherein the method comprises at least a lapping process by use of loose abrasive grains and an etching process by use of an alkaline etching solution, lapping is performed in the lapping process by use of abrasive grains having a maximum grain diameter of 21 µm or less and an average grain diameter of 8.5 µm or less serving as the loose abrasive grains, and after that, etching is performed in the etching process by use of an alkaline solution having a concentration of an alkaline component of 50% by weight or more serving as the alkaline etching solution.

2. The method for producing a silicon wafer according to claim 1, wherein the alkaline component in the alkaline solution is sodium hydroxide.

3. The method for producing a silicon wafer according to claim 1 or 2, wherein the etching is performed while controlling a temperature of the alkaline solution within a range of 80-300°C.

4. The method for producing a silicon wafer according to any one of claims 1-3, wherein an alumina based fine lapping material is used as the loose abrasive grain.

5. The method for producing a silicon wafer according to claim 4, wherein the alumina based fine lapping material is an artificial emery lapping material made of a mixture of alumina abrasive grains and zircon abrasive grains.

6. The method for producing a silicon wafer according to any one of claims 1-5, wherein the concentration of the alkaline component in the alkaline solution is 70% by weight or less.

7. A silicon wafer produced by the method according to any one of claims 1-6.

8. A silicon wafer, wherein both sides of the wafer are etched surfaces, and in a peripheral portion of the wafer except a region within 1 mm from a peripheral end of the wafer on the etched surfaces, an absolute value of a minimum value (sag) of a thickness difference of a shape in the peripheral portion of the wafer against a reference surface obtained from a thickness displacement of the wafer surface in a central region of the wafer is 0.2 µm or less.

9. The silicon wafer according to claim 8, wherein in the peripheral portion of the wafer except a region within 1 mm from a peripheral end of the wafer on the etched surfaces, an absolute value of a maximum value (rise) of a thickness difference of a shape in the peripheral portion of the wafer against the reference surface is 0.2 µm or less.

10. The silicon wafer according to claim 8 or 9, wherein a plane orientation of the silicon wafer is (100), and the etched surfaces of the silicon wafer have etch pits forming square-shaped openings with four sides along a crystal orientation <110>.

11. The silicon wafer according to claim 10, wherein an average size of the etch pits is 6 µm or less.

12. The silicon wafer according to claim 8 or 9, wherein a conductivity type is p-type, a resistivity is 0.01 Ω • cm or less, a plane orientation is (100), and the etched surfaces of the silicon wafer have etch pits forming square-shaped openings with four sides along a crystal orientation <110>.

13. The silicon wafer according to claim 12, wherein an average size of the etch pits is 7 µm or less.

14. The silicon wafer according to any one of claims 8-13, wherein on the etched surfaces in a central region of the wafer, an average value of a variation (waviness) of a thickness displacement on the wafer surface is 0.04 µm or less.

15. A silicon wafer, wherein at least one side of the etched surfaces of the silicon wafer according to any one of claims 8-14 is mirror-polished.

16. The silicon wafer according to claim 15, wherein in a peripheral portion of the wafer except a region within 1 mm from a peripheral end of the wafer on the mirror-polished surface of the silicon wafer, an absolute value of a minimum value (sag) of a thickness difference of a shape in the peripheral portion of the wafer against a reference surface obtained from a thickness displacement of the wafer surface in a central region of the wafer is 0.5 µm or less.

17. The silicon wafer according to claim 15 or 16, wherein in a peripheral portion of the wafer except a region within 1 mm from a peripheral end of the wafer on the mirror-polished surface, an absolute value of a maximum value (rise) of a thickness difference of a shape in the peripheral portion of the wafer against a reference surface obtained from a thickness displacement of the wafer surface in a central region of the wafer is 0.07 µm or less.

18. An SOI wafer having a structure such that an insulator film and an SOI layer are laminated in order on the mirror-polished surface of the silicon wafer according to any one of claims 15-17.

19. A silicon wafer, wherein the silicon wafer has an etched surface on at least one main surface side, an plain orientation of the silicon wafer is (100), the etched surface has etch pits forming square-shaped openings with four sides along a crystal orientation <110>, and an average size of the etch pits is 6 µm or less.

20. A silicon wafer, wherein the silicon wafer has an etched surface on at least one main surface side, a conductivity type is p-type, resistivity is 0.01 Ω • cm or less, a plane orientation of the silicon wafer is (100), the etched surface has etch pits forming square-shaped openings with four sides along a crystal orientation <110>, and an average size of the etch pits is 7 µm or less.

21. The silicon wafer according to claim 19 or 20, wherein on the etched surfaces in a central region of the wafer, an average value of a variation (waviness) of a thickness displacement on the wafer surface is 0.04 µm or less.

22. The silicon wafer according to any one of claims 19-21, wherein a main surface which is the opposite side of the etched surface is a mirror-polished surface.

23. An SOI wafer having a structure such that an insulator film and an SOI layer are laminated in order on the mirror-polished surface of the silicon wafer according to claim 22.
